# EUROPEAN PATENT APPLICATION

(11) **EP 2 226 736 A1**
(43) Date of publication of application: **08.09.2010**
(21) Application number: 10153332.1
(22) Date of filing: 11.02.2010
(51) Int. Cl.: G06F 17/50

(54) **Layout verification method**

(30) Priority: 06.03.2009 JP 2009054146
(71) Applicant: Fujitsu Semiconductor Limited, Kohoku-ku, Yokohama-shi Kanagawa 222-0033 (JP)
(72) Inventor: Mizuno, Yutaka, Yokohama-shi, Kanagawa 222-0033 (JP); Yamada, Tomoyuki, Yokohama-shi, Kanagawa 222-0033 (JP)
(74) Representative: Stebbing, Timothy Charles

(57) **Abstract**

A layout verification method for verifying a layout (100) of a semiconductor device by a computer having a memory storing layout data and information of operation conditions for a plurality of operation modes in which the semiconductor device is expected to assume during its testing and practical use, the semiconductor device including a semiconductor substrate of one conductivity type, a plurality of wells accommodating at least one of the circuit elements and being applicable to a plurality of different bias voltages in dependence on the operation modes. The method includes specifying combinations of all the adjacent pairs (901, 902) of wells located adjacently to each other within the semiconductor substrate, and the interval between adjacent pairs of wells in reference to the layout data, determining, for each of the wells, one or more applicable bias voltages to be applied in each of the operation modes by reference to the layout data and the information of the operation conditions, determining, for each adjacent pair of wells, a maximum voltage difference between the applicable bias voltages to be applied to that adjacent pair of wells among all the operation modes in reference to the operation conditions, and verifying if the interval between each adjacent pair is within a respective permissive range determined by the corresponding maximum voltage difference between the applicable bias voltages to be applied to each adjacent pair of wells for all the combinations thereof.

## Description

The present invention relates to a layout verification method of a semiconductor device.

Hitherto, when some different power supply lines are needed in a circuit, each device constituting the circuit is designed to function at the voltage of the corresponding power supply line. Japanese Laid-open Patent Publication No. 2004-252717 discusses a technique that a plurality of devices are laid out in areas having heterogeneous operation circumstances with a required interval (distance) therebetween in case of using a plurality of types of devices. The expression, "a plurality of types of devices" may refer to a plurality of devices of different withstand voltages, for example.

More specifically, for example, an area containing a device connected to a power supply voltage set up to 1.2 V and another area containing a device connected to a power supply voltage set up to 3 V represent heterogeneous operation circumstances. The intervals required between homogeneous areas and the intervals required between heterogeneous areas depend on design rules.

Another technology for verifying the layout having a plurality of types of devices has been known that verifies whether the intervals between the areas are compliant with a design rule or not by referring data regarding devices of interest from data regarding the layout. Japanese Laid-open Patent Publication No. 2005-208837 discusses a technique for judging whether the intervals between areas are compliant with a design rule or not on the basis of the types of devices and potential levels of the devices when all devices contained in all the areas in question are coupled in a circuit connected to one same terminal.

It is desirable to provide a layout verification method allowing verification in accordance with a plurality of operation modes of the semiconductor device.

According to an aspect of the invention, there is provided a layout verification method for verifying a layout of a semiconductor device by a computer having a memory storing layout data and information of operation conditions for a plurality of operation modes in which the semiconductor device is expected to assume during its testing and practical use, the semiconductor device including a semiconductor substrate of one conductivity type, a plurality of wells accommodating at least one of the circuit elements and being applicable to a plurality of different bias voltages in dependence on the operation modes, the method including specifying combinations of all the adjacent pairs of the wells located adjacently to each other within the semiconductor substrate, and the distance of (interval between) each adjacent pair of wells in reference to the layout data, determining, for each of the wells, one or more applicable bias voltages to be applied in each of the operation modes in reference to the layout data and the information of the operation conditions, determining, for each adjacent pair of wells, a maximum voltage difference between the applicable bias voltages to be applied to each adjacent pair of wells among all the operation modes in reference to the operation conditions, and verifying if the distance between each adjacent pair is within a respective permissive range determined by the corresponding maximum voltage difference between the applicable bias voltages to be applied to said each adjacent pair of wells for all the combinations thereof.

The advantages of the invention will be realized and attained by means of the elements and combinations particularly pointed out in the claims.

It is to be understood that both the foregoing general description and the following detailed description are exemplary and explanatory and are not restrictive of the invention, as claimed.
Reference is made, by way of example only, to the accompanying drawings in which:

FIG. 1 is an explanatory diagram illustrating an example where areas are classified in accordance with differences in input voltages;

FIG. 2 is an explanatory diagram illustrating a test/operation item set;

FIG. 3 is a block diagram illustrating a hardware configuration of a layout verification apparatus according to an embodiment;

FIG. 4 is a block diagram illustrating a functional configuration of a layout verification apparatus;

FIG. 5 is an explanatory diagram illustrating determined design rules;

FIG. 6 is a flowchart illustrating layout verifying processing based on differences in input voltage;

FIG. 7 is a flowchart illustrating design rule determining processing;

FIG. 8 is a flowchart illustrating verifying processing;

FIG. 9A is a conceptual diagram of layout on a semiconductor integrated circuit including a plurality of power supply lines and terminals;

FIG. 9B is an explanatory diagram illustrating a design rule for heterogeneous areas; and

FIG. 9C is an explanatory diagram illustrating a design rule for homogeneous areas.

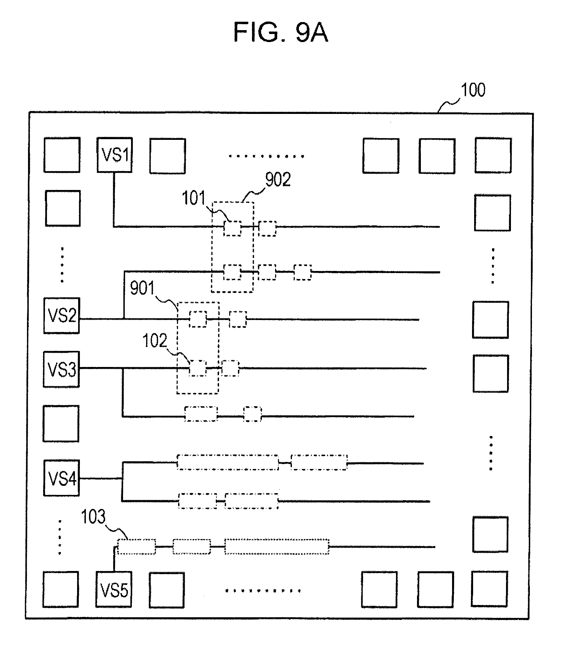

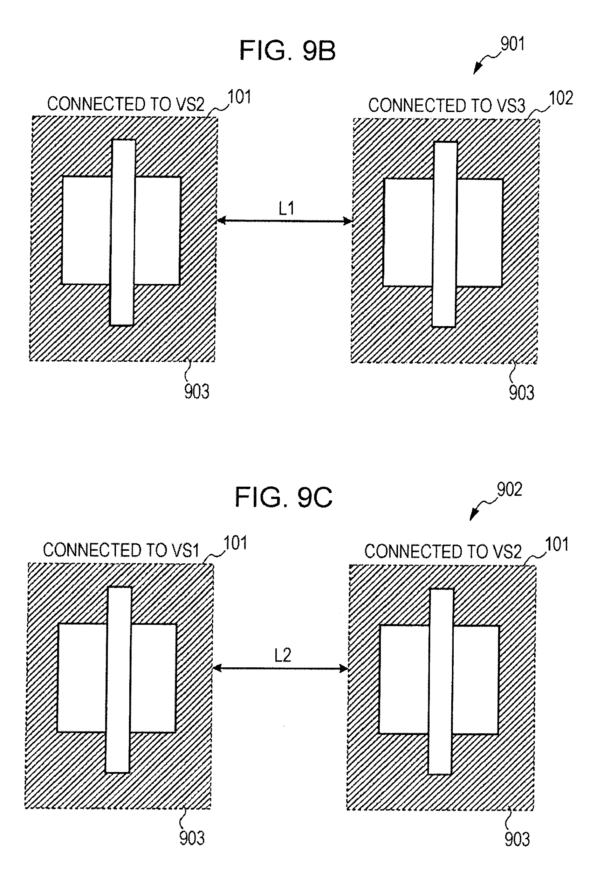

As described previously, FIGs. 9A to 9C illustrate examples of layout and individual elements to be checked on the basis of a design rule. FIG. 9A is a conceptual diagram of a layout on a semiconductor integrated circuit including a plurality of power supply lines and terminals. The layout 100 includes power supply terminals VS1 to VS5. For easy understanding, the configuration of areas and the specific wiring thereamong are omitted herein. A power supply line connecting to VS1 and another power supply line connecting to VS2 include areas 101. This means that a pair 902 includes homogeneous areas. Meanwhile, the power supply line connecting to VS3 includes areas 102. This means that a pair 901 includes heterogeneous areas. The power supply line connecting to the VS5 includes areas 103. FIG. 9B illustrates a design rule which is applied to the heterogeneous areas.

FIG. 9B is an explanatory diagram illustrating a design rule for heterogeneous areas. For easy understanding, the wiring among the areas is omitted herein. Each of the areas 101 and areas 102 include an N-well 903, an active region constituting a source region and a drain region, and a Poly-gate. The verification based on the types of areas may include, for example, identifying the types of the areas and performing the verification for each type on the basis of the layer numbers assigned to components of the areas, the sizes of the components, and/or the arrangement of the components with respect to each other.

In FIG. 9B, the interval between areas is equal to the interval between the N-well 903 and the N-well 903. The interval between heterogeneous areas is L1 [µm] according to the design rule, and the interval between one of the areas 101 connected to the VS2 and one of the areas 102 connected to the VS3 is L1 [µm]. Next, FIG. 9C illustrates a design rule between homogeneous areas.

FIG. 9C is an explanatory diagram illustrating a design rule for homogeneous areas. In FIG. 9C, the design rule for the interval between one of the areas 101 connected to the VS1 and one of the areas 101 connected to the VS2 is L2 [µm].

The interval between heterogeneous areas may be longer than the interval between homogeneous areas. For example, when the interval between heterogeneous areas is equal to the design rule for the interval between homogeneous areas, a leak current may occur between the heterogeneous areas because of a parasitic transistor formed by the two opposing areas and the intervening interval portion could be turned on under heterogeneous operation circumstances. The leak current may occur when a plurality of different bias voltages in dependence with the operation mode are applied between the pluralities of adjacent wells. The amplification factor of the parasitic transistor formed by the adjacent wells depends on the interval between the wells. When the interval between heterogeneous becomes smaller, the amplification factor of the parasitic transistor may increase. The larger the amplification factor of the parasitic transistor is, the greater the risk of undesirable occurrence of latch up is. Thus, L1 is defined to a value longer than L2.

However, the technology that detects only the types of areas from data regarding layout does not verify the layout when the potential levels are different between the areas even though the areas are homogeneous. For example, the potential levels of the devices may differ because the input voltages of the connected terminals are different. The input voltages of terminals vary in accordance with the test/operation items. A test/operation item may be an itemized input voltage of a terminal, which is determined for each type of a test or an operation defined in specifications, for example.

In accordance with some test/operation items, the input voltages of terminals using homogeneous areas may differ. In this case, the potential levels are different between the devices connecting to the terminals. Since the potential levels differ even between the homogeneous areas, leak current may occur between the homogeneous areas when the intervals are equal to the design rule for the homogeneous areas. Thus, a layout designer may grasp all of the types of test/operation items and/or the input voltages of the terminals, determine the design rule, and verify it.

With reference to attached drawings, a preferred embodiment of the layout verification method and layout verification apparatus will be described in detail.

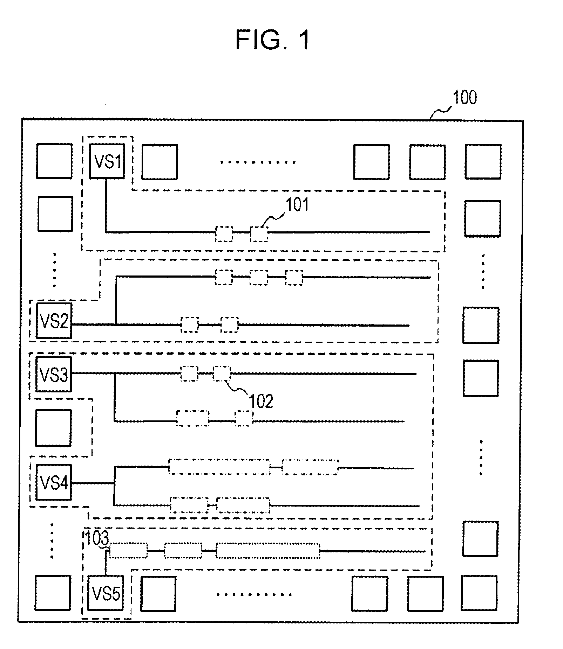

According to an embodiment, a design rule for the areas connected to terminals of interest is determined on the basis of input voltages applied to the terminals, which are known from a test/operation item set. Thus, a designer may determine a design rule without identifying the types of test/operation items. Therefore, the verification is allowed without being aware of changes in potential of areas. FIG. 1 illustrates an example where areas are grouped in accordance with the input voltages.

FIG. 1 is an explanatory diagram illustrating an example that areas are grouped in accordance with input voltages. In layout 100, areas connected to terminals are grouped in accordance with the input voltages for all test/operation items (where the classified areas are enclosed by the dashed lines). Devices are not grouped according to this embodiment but are grouped here for easy understanding.

In FIG. 1, the areas connected to the VS1 and VS2 are homogeneous areas but have different input voltages. Thus, as the design rule to be applied to the areas connected to the terminals, the design rule for heterogeneous areas is used. The areas connected to the VS3 and VS4 are homogeneous areas and have an equal input voltage. Therefore, as the design rule to be applied to the areas connected to the terminals, the design rule for homogeneous areas is used. The data regarding layout 100 is stored in a storage device.

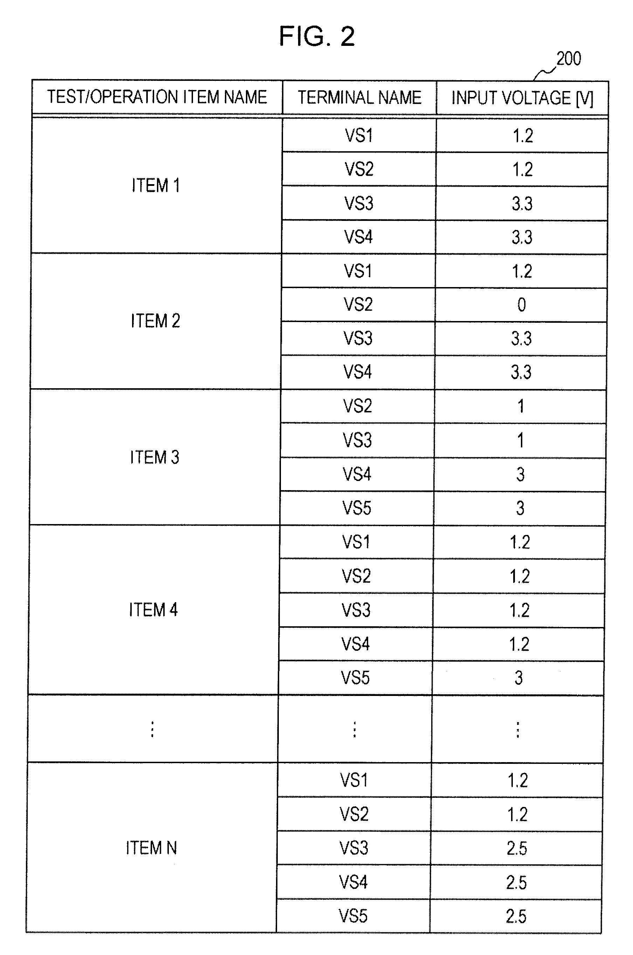

FIG. 2 is an explanatory diagram illustrating a test/operation item set. A test/operation item set 200 holds test/operation item names, terminal names, and information on the input voltages of terminals. For example, Item 1 holds information on input voltages of the VS1, VS2, VS3 and VS4. However, the test/operation item set 200 does not hold the information on the test or operation listed as an Item 1. The data of the test/operation item set 200 is stored in a storage device.

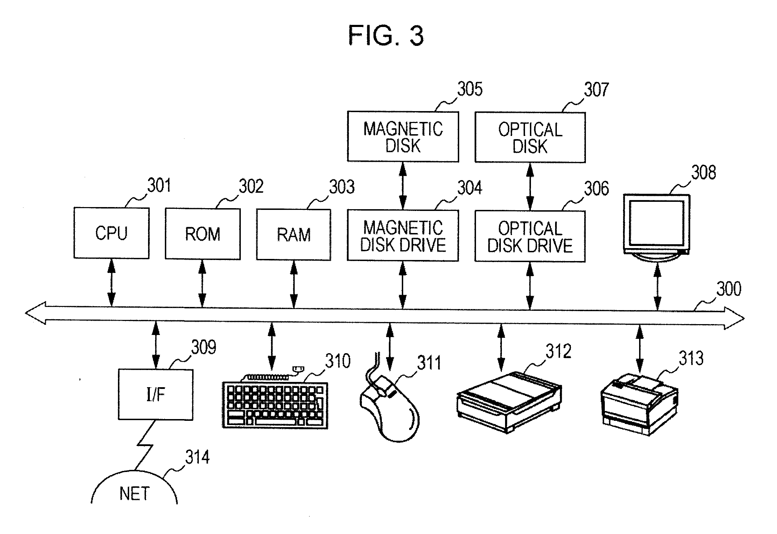

FIG. 3 is a block diagram illustrating a hardware configuration of a layout verification apparatus according to an embodiment. In FIG. 3, the layout verification apparatus includes a CPU (central processing unit) 301, a ROM (read-only memory) 302, a RAM (random access memory) 303, a magnetic disk drive 304, a magnetic disk 305, an optical disk drive 306, an optical disk 307, a display 308, an I/F (interface) 309, a keyboard 310, a mouse 311, a scanner 312, and a printer 313. These components are connected via a bus 300.

The CPU 301 is responsible for control over the entire layout verification apparatus. The ROM 302 stores programs such as a boot program and a layout verification program. The RAM 303 is used as a work area for the CPU 301. The magnetic disk drive 304 controls reading/writing data from/to the magnetic disk 305 under the control of the CPU 301. The magnetic disk 305 stores data written by controlling the magnetic disk drive 304.

The optical disk drive 306 controls reading/writing data from/to the optical disk 307 under the control of the CPU 301. The optical disk 307 may store data written by controlling the optical disk drive 306 and may cause a computer to read data stored on the optical disk 307.

The display 308 displays data on a cursor, an icon, a toolbox, a document, an image, and functional information, for example. The display 308 may be a CRT, a TFT liquid crystal display or a plasma display, for example.

The interface (which will be abbreviated to I/F hereinafter) 309 is connected via a communication line to a network 314 such as a LAN (local area network), a WAN (wide area network), and the Internet and is connected over the network 314 to another apparatus. The I/F 309 is responsible for an internal interface to/from the network 314 and controls the input/output of data to/from an external device. The I/F 309 may be a modem or a LAN adapter, for example.

The keyboard 310 has keys for inputting characters, numbers and instructions and is used for inputting data. The keyboard 310 may be a touch-panel input pad or a numeric keypad, for example. The mouse 311 may be used for moving a cursor, selecting a range, moving a window or changing the size of a window. The mouse 311 may be a trackball or a joystick if it has the functions similarly to a pointing device.

The scanner 312 optically reads an image and captures the image data into the layout verification apparatus. The scanner 312 may have an OCR (optical character reader) function. The printer 313 prints image data or document data, for example. The printer 313 may be a laser printer or an ink-jet printer.

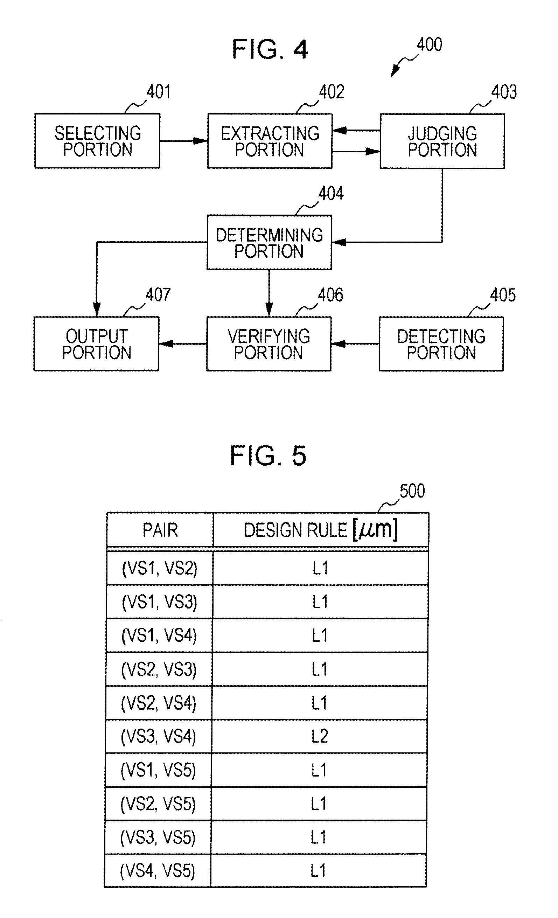

Next, the functional configuration of the layout verification apparatus will be described. FIG. 4 is a block diagram illustrating a functional configuration of the layout verification apparatus. A layout verification apparatus 400 includes a selecting portion 401, an extracting section 402, a judging portion 403, a determining portion 404, a detecting portion 405, a verifying portion 406, and an output portion 407. The selecting portion 401, extracting section 402, judging portion 403, determining portion 404, detecting portion 405, verifying portion 406, and output portion 407 implement their functions by, more specifically, causing the CPU 301 to execute programs stored in a storage device such as the ROM 302, RAM 303, magnetic disk 305, and optical disk 307 illustrated in FIG. 3 or through the I/F 309.

According to this embodiment, there will be described a case where one item within the test/operation item set 200 is only used to determine the design rule for intervals between devices connected to terminals and a case where all items within the test/operation item set 200 are used to determine the design rule for intervals between devices connected to terminals. The former will be described first, and the latter will then be described.

The selecting portion 401 selects a target item from the test/operation item set 200. More specifically, for example, the CPU 301 may access a storage device, select one item from the test/operation item set 200, and handle the selected item as the target item. For example, the selected item may be added (marked, tagged or labelled with) identification information indicating that it is a target item and be stored in a storage device such as the RAM 303 and the magnetic disk 305. For example, Item 1 may be selected as the target item in the increasing order of the item numbers.

The extracting section 402 extracts a pair of terminals from a plurality of terminals within the target item selected by the selecting portion 401. More specifically, for example, the CPU 301 may access the storage device and read information on the target item on the basis of the identification information. Next, a pair of terminals is selected from terminals under the terminal names within the target item, and the corresponding input voltages are extracted. The terminal names and the corresponding input voltages are added the (marked with) identification information indicating that they are a pair of terminals and are stored to a storage device such as the RAM 303 and magnetic disk 305.

For example, the VS1 and VS2 may be extracted as a pair of terminals from the terminal names within Item 1 selected as a target item. Then, the input voltage 1.2 [V] of the VS1 and the input voltage 1.2 [V] of the VS2 may be extracted.

The judging portion 403 judges the difference between the input voltages of the pair of terminals extracted by the extracting section 402. More specifically, for example, the CPU 301 may access the storage device and reads the information on the extracted pair of terminals on the basis of the identification information. Next, the input voltages of the pair of terminals are compared, and the difference is judged. The judgment result may be stored in a storage device such as the RAM 303 and magnetic disk 305.

For example, the input voltage of the VS1 and the input voltage of the VS2 extracted from Item 1 may be compared. Since the input voltage of the VS1 and the input voltage of the VS2 are both 1.2 [V] and are equal, the VS1 and VS2 are judged as having an equal input voltage.

The determining portion 404 determines the design rule applicable to the intervals for one device group connected to one terminal of the pair of terminals and the other device group connected to the other terminal as the design rule based on the judgment result of the judgment by the judging portion 403.

More specifically, for example, the CPU 301 may access the storage device and read the judgment result. Next, if the judgment result is that the input voltages are equal, the design rule applicable to the intervals for one device group connected to one terminal of the pair of terminals and the other device group connected to the other terminal is determined as the design rule for homogeneous areas. If the judgment result is that the input voltages are different, it is determined as the design rule for heterogeneous areas.

For example, only with the input voltage within Item 1, the design rule applicable to the intervals for the device group connected to the VS1 and the device group connected to the VS2 may be determined as L2 that is a design rule for homogeneous areas.

Thus, the layout may be verified without the identification of the type of the test/operation item. This means that the layout may be verified without being aware of changes in potential levels of the areas according to the test/operation items. Furthermore, the difference between the device groups connected to a pair of terminals may be verified on the basis of the difference in input voltage. This may eliminate the time and labor for manually judging the design rules by a user (or a designer or a verifying stuff) and may reduce the load on the user.

Since a design rule is determined for each item, the determination of a design rule based on an unnecessary item may be prevented when the test/operation item set 200 contains an unnecessary item.

Next, there will be described the processing by the extracting section 402, judging portion 403, and determining portion 404 for using all items within the test/operation item set 200 to determine the design rule for intervals for device groups connected to terminals.

If the judging portion 403 judges that the input voltages of a pair of terminals are equal, the extracting section 402 extracts all test/operation items including the pair of terminals from the remaining test/operation items.

More specifically, for example, the CPU 301 may access the storage device and read the judgment result regarding the pair of terminals of the target item. If the judgment result is that the input voltages are equal, all test/operation items are extracted including the terminal names of the pair of terminals from the test/operation item set 200. The extraction result is stored in a storage device such as the RAM 303 and magnetic disk 305.

For example, since it is judged that the VS1 and VS2 have an equal input voltage in Item 1, an item or items including both of the terminals VS1 and VS2 is or are retrieved. Since Item 2, Item 4, and Item N include the VS1 and VS2, they are extracted as the test/operation items including the pair of terminals. However, since Item 3 does not include terminal VS1, it is not extracted as the test/operation item including the pair of terminals.

Next, the judging portion 403 judges the difference in input voltages of the pair of terminals in all of the test/operation items extracted by the extracting section 402. More specifically, for example, the CPU 301 may access the storage device and read the extraction result. Then, the input voltages of the pair of terminals of each of the items are compared to judge whether they are equal or not. The judgment result is stored in a storage device such as the RAM 303 and magnetic disk 305.

For example, first of all, the input voltages of the VS1 and VS2 within Item 2 are compared. In Item 2, since the VS1 has 1.2 [V] and the VS2 has 0 [V], the input voltages are judged as different. Next, in Item 4, since the VS1 has 1.2 [V] and the VS2 has 1.2 [V], the input voltages are judge as equal. In Item N, since the VS1 has 1.2 [V] and the VS2 has 1.2 [V], the input voltages are judged as equal.

Next, the determining portion 404 determines the design rule applicable to the intervals for one device group connected to one terminal of the pair of terminals and the other device group connected to the other terminal in accordance with the case where the judging portion 403 judges that they are equal in all items and the case where the judging portion 403 judges that any (even some one) item is different.

More specifically, for example, the CPU 301 may access the storage device and read the judgment result. Then, the design rule applicable to the intervals for one device group connected to one terminal of the pair of terminals and the other device group connected to the other terminal is determined as the design rule for homogeneous areas if the input voltages are judged as equal in all items. It is determined as a design rule for heterogeneous areas if even one item is judged different. The determination result is stored in a storage device such as the RAM 303 and magnetic disk 305.

For example, in Item 2, since it is judged that the input voltages of the VS1 and VS2 are different, the design rule applicable to the intervals for the device group connected to the VS1 and the device group connected to the VS2 is determined to the L1.

When all items within the test/operation item set 200 are indispensable, all of the test/operation items may be used to determine the design rules. Thus, compared with the case where the design rule is determined for each item, the number of times of the verification may be reduced. Thus, the verification time may be reduced.

When even a single item has a different input voltage, the layout may be verified with a design rule for heterogeneous areas, which is stricter than the design rule for homogeneous areas. This may eliminate the necessity for verification on items having an equal input voltage. Thus, the verification time may be reduced.

The output portion 407 has a function of outputting a determination result by the determining portion 404. More specifically, for example, the CPU 301 may output a determination result stored in a storage device. The determination result may be output by, for example, displaying on the display 308, printing through the printer 313, or transmitting through the I/F 309 to an external device. The determination result may be output by storing it to a storage device such as the RAM 303 and magnetic disk 305. FIG. 5 illustrates an example of the output of the determination results.

FIG. 5 is an explanatory diagram illustrating the determined design rules. A table 500 is an example of the output including design rules determined by using all items within the test/operation item set 200. The table 500 includes pairs of terminals and the determined design rules. For example, the expression "(VS1, VS2)" refers to the VS1 and the VS2. Thus, FIG. 5 illustrates that the design rule applicable to the intervals for the device group connected to the VS1 and the device group connected to the VS2 is L1.

Referring back to FIG. 4, the output portion 407 has a function of outputting a verification result of verification by the verifying portion 406, as will be described later. More specifically, for example, the CPU 301 may output the verification result. The verification result may be output by, for example, displaying on the display 308, printing through the printer 313, or transmitting through the I/F 309 to an external device. The verification result may be stored in a storage device such as the RAM 303 and the magnetic disk 305.

The detecting portion 405 detects the intervals for one device group connected to one terminal of a pair of terminals and the other device group connected to the other terminal from data regarding the layout.

More specifically, for example, the CPU 301 may access the storage device and extract all devices connected to one terminal of a pair of terminals within the layout. All the extracted devices are tagged with identification information indicating that they belong to one device group connected to one terminal and are stored in a storage device such as the RAM 303 and magnetic disk 305.

Next, for example, the CPU 301 may access the storage device and extract all devices connected to the other terminal of the pair of terminals. Then, all the extracted devices are marked as belonging to the other device group connected to the other terminal and are stored in a storage device such as the RAM 303 and magnetic disk 305.

Next, for example, the CPU 301 may detect the shortest interval between one device group and the other device group. Then, the detected interval is handled as the intervals for one device group connected to one terminal of the pair of terminals and the other device group connected to the other terminal. For example, the detection result may be labelled as the interval between the one device group and the other device group and stored in a storage device such as the RAM 303 and magnetic disk 305.

The verifying portion 406 verifies whether the interval detected by the detecting portion 405 is compliant with the design rule determined by the determining portion 404 or not. More specifically, for example, the CPU 301 may access the storage apparatus and read the interval between one device group and the other device group on the basis of the identification information. Next, the CPU 301 may access the storage device and read the design rule. Then, the interval between the one device group and the other device group and the design rule are compared.

For example, if the interval between the one device group and the other device group is equal to or larger than the design rule, the CPU 301 judges that the interval is compliant with the design rule. If the interval between the one device group and the other device group is smaller than the design rule, the CPU 301 judges that the interval is not compliant with the design rule.

For example, for the devices connecting to the VS1 or VS2, an interval therebetween determined by the design rule is L1 when all items within the test/operation item set 200 are used. The interval between the pair of devices in a pair 902 is handled as the shortest interval for the device groups connected to the VS1 or the VS2. As described above, the interval between the pair of devices in the pair 902 is designed as L2. Thus, the interval between the pair of devices in the pair 902 is judged as a shorter interval than L1 being the determined design rule. Therefore, it is verified that the device group connected to the VS1 and the device group connected to the VS2 are not compliant with the design rule.

This allows the layout verification based on the difference in input voltages among terminals regardless of the types of devices. Thus, the precision of the verification may be improved.

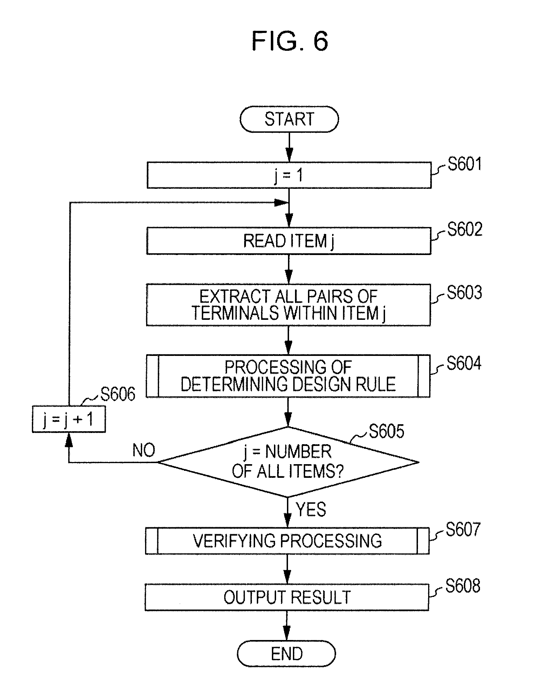

FIG. 6 is a flowchart illustrating layout verifying processing based on differences in input voltage. Referring to FIG. 6, there will be described a case where all items within the test/operation item set 200 are used. Referring to FIG. 6, the selecting portion 401 first defines j = 1 (step S601) and selects Item J. Next, Item J is read from the test/operation item set 200 (step S602). The step S602 indicates specifying the combination of all the adjacent pairs of the wells located adjacently to each other within the semiconductor substrate, and the distance of each of all the adjacent pairs of the wells in reference to the layout data. Then, the extracting section 402 extracts pairs of all terminals within Item J (step S603). The step S603 indicates determining, for each of the wells, one or more applicable bias voltages to be applied to each of the wells for each of the operation modes in reference to the layout data and the information of the operation conditions. Next, the design rule determining processing is performed (step S604). The step S604 indicates the determining, for each of all the adjacent pairs of the wells, of a maximum voltage difference between the applicable bias voltages to be applied to each of all the adjacent pairs of wells among all the operation modes in reference to the operation conditions. Then, the design rule determining processing is performed whether j = the number of all items or not is judged (step S605). If it is judged that j is not equal to the number of all items (step S605: No), the selecting portion 401 defines j = j + 1 (step S606) and returns to step S602.

On the other hand, if it is judged that j = the number of all items (step S605: Yes), verifying processing is next performed (step S607). The step S607 indicates verifying whether the distance of (interval between) each of all the adjacent pairs is within a respective permissive range determined by the corresponding maximum voltage difference between the applicable bias voltages to be applied to said each of the all adjacent pairs of the wells for all the combinations of all the adjacent pair of the wells. The output portion 407 outputs the verification result (step S608), and the processing routine ends.

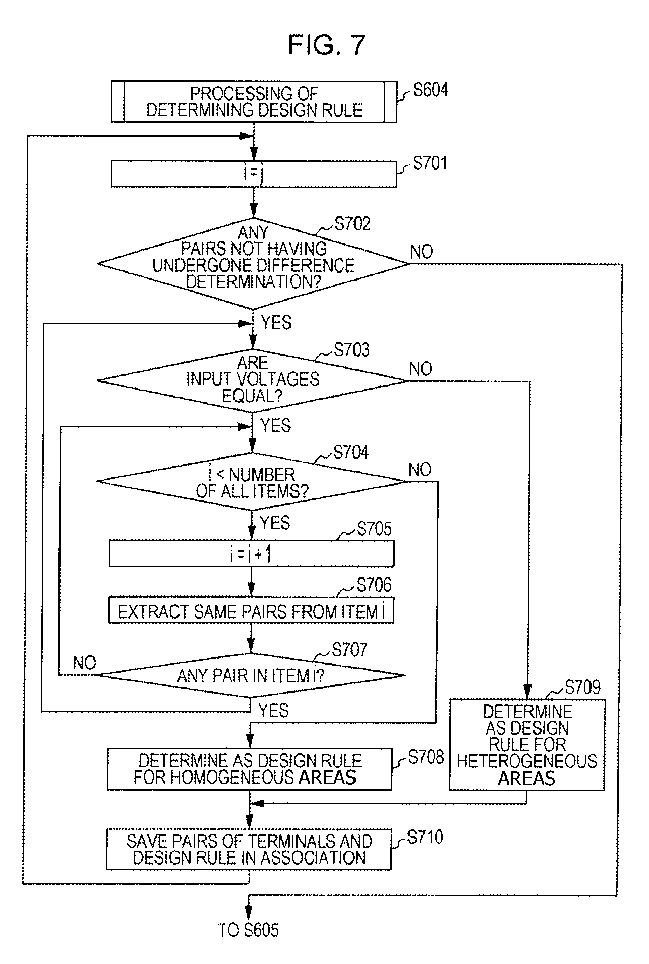

Next, the design rule determining processing (step S604) will be described. FIG. 7 is a flowchart illustrating design rule determining processing. Referring to FIG. 7, i= j is first defined (step S701), and whether any pair has not undergone the judgment on the difference in input voltage or not is determined (step S702). If it is determined that some pair has not undergone the judgment on the difference in input voltage (step S702: Yes), the judging portion 403 judges whether the input voltages are equal or not (step S703).

If it is judged that the input voltages are equal (step S703: Yes), whether i < the number of all items or not is judged (step S704). If it is judged that i < the number of all items (step S704: Yes), i = i + 1 is defined (step S705). The extracting section 402 extracts a pair or pairs of terminals having an equal input voltage from Item i (step S706) and then judges whether any pair is present in Item i (step S707).

If it is judged that Item i has a pair (step S707: Yes), the processing returns to step S703. If it is judged that Item i does not have a pair (step S707: No), the processing returns to step S704.

On the other hand, if it is judged that i is not smaller than the number of all items (step S704: No), the determining portion 404 determines the design rule for the one device group and the other device group as the design rule for homogeneous areas (step S708) and saves the pairs of terminals and the design rule in association (step S710). The processing moves to step S701.

On the other hand, if it is judged that the input voltages are not equal (step S703: No), the determining portion 404 determines the design rule for the one device group and the other device group as the design rule for heterogeneous areas (step S709). The processing moves to step S710.

On the other hand, if it is judged that there are no pairs not having undergone the judgment on the difference in input voltage (step S702: No), the processing moves to step S605.

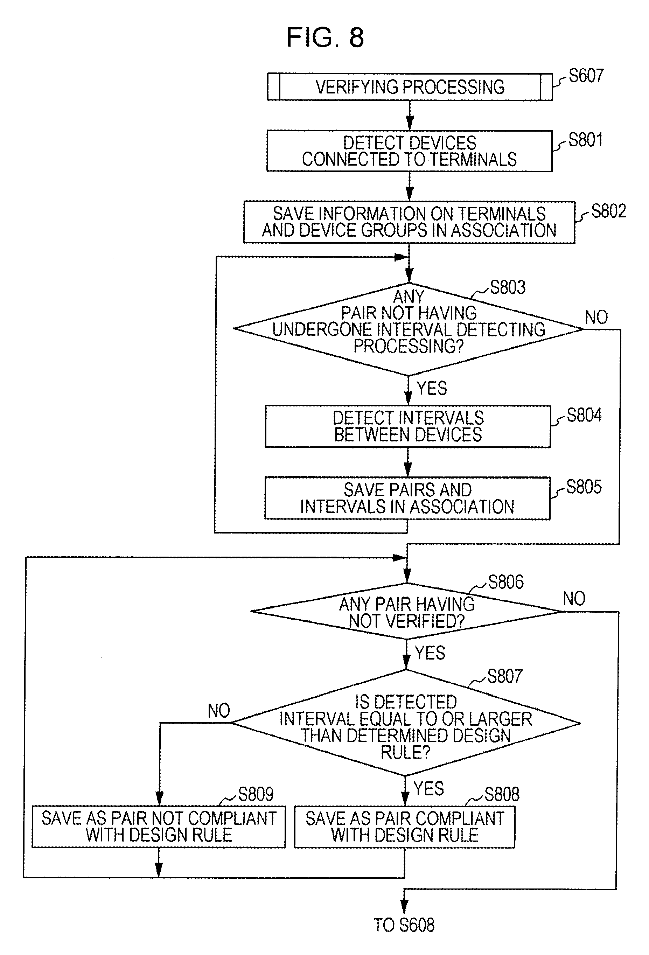

Next, the verifying processing (step S607) will be described. FIG. 8 is a flowchart illustrating the verifying processing. Referring to FIG. 8, the detecting portion 405 first detects devices connected to terminals (step S801), saves the information on the terminals and devices in association (step S802), and judges whether any pair has not undergone the interval detecting processing or not (step S803).

If it is judged that there is some pair not having undergone the interval detecting processing (step S803: Yes), the detecting portion 405 detects the intervals between the detected devices (step S804), and saves the pairs and intervals in association (step S805). The processing returns to step S803.

On the other hand, if it is judged that there are no pairs not having undergone the interval detecting processing (step S803: No), whether there is any pair not having been verified is judged (step S806). If it is judged that there is some pair not verified (step S806: Yes), the verifying portion 406 judges whether the detected interval is equal to or larger than the determined design rule or not (step S807).

If it is judged that the detected interval is equal to or larger than the determined design rule (step S807: Yes), the pair is saved as a pair compliant with the design rule (step S808), and the processing returns to step S806. On the other hand, if it is judged that the detected interval is not equal to or larger than the determined design rule (step S807: No), the pair is saved as a pair not compliant with the design rule (step S809), and the processing returns to step S806.

On the other hand, if it is judged that there is some pair not having been verified (step S806: No), the processing moves to step S608.

As described above, according to the layout verification method and layout verification apparatus, the design rule applicable to the intervals for one device group connected to one terminal of the pair of terminals and the other device group connected to the other terminal is determined on the basis of the difference in input voltage between a pair of terminals. Thus, a layout may be verified without the identification of the types of the test/operation items, and a layout may be verified without being aware of the changes in potential levels of devices based on the test/operation items.

If the input voltages of a pair of terminals are equal, the interval is determined as the design rule for homogeneous areas. If it is judged that they are different, the interval is determined as the design rule for heterogeneous areas. Thus, the difference between the areas connected to a pair of terminals may be verified on the basis of the difference in input voltage. This may eliminate the time and labor for manually judging the design rules by a user and may reduce the load on the user.

If it is judged that the input voltages are equal in all test/operation items including a pair of terminals, the interval is determined as the design rule for homogeneous areas. If it is judged that the input voltages are different even in one item including a pair of terminals, the interval is determined as the design rule for heterogeneous areas.

When all items within the test/operation item set 200 are indispensable item, all of the test/operation items may be used to determine the design rules. Thus, compared with the case where the design rule is determined for each item, the number of times of the verification may be reduced. Thus, the verification time may be reduced.

Where any item has a different input voltage, the layout may be verified with a design rule for heterogeneous areas, which is stricter than the design rule for homogeneous areas. This may eliminate the necessity for verification on items having an equal input voltage. Thus, the verification time may be reduced.

The verification based on the determined design rule allows the layout verification based on the difference in input voltages between terminals regardless of the types of devices. Thus, the precision of the verification may be improved.

The detection of the intervals between one device group and the other device group and verification on the detection results allows the layout verification based on the difference in input voltages between terminals regardless of the types of devices. Thus, the precision of the verification may be improved.

The layout verification method according to this embodiment may be implemented by causing a computer such as a personal computer and a workstation to execute a prepared program. The program may be recorded in a computer-readable recording medium such as a hard disk, a flexible disk, a CD-ROM, an MO and a DVD and be loaded from the recording medium and executed by a computer. The program may be a medium that may be distributed over a network such as the Internet.

All examples and conditional language recited herein are intended for pedagogical purposes to aid the reader in understanding the embodiment and the concepts contributed by the inventor to furthering the art, and are to be construed as being without limitation to such specifically recited examples and conditions, nor does the organization of such examples in the specification relate to a illustrating of the superiority and inferiority of the embodiment. Although the embodiments of the present invention have been described in detail, it should be understood that the various changes, substitutions, and alterations could be made hereto without departing from the scope of the claims.

## Claims

1. A layout verification method for verifying a layout of a semiconductor device by a computer having a memory storing layout data and information of operation conditions for a plurality of operation modes in which the semiconductor device is expected to assume during its testing and practical use, the semiconductor device including a semiconductor substrate of one conductivity type, a plurality of wells accommodating at least one of the circuit elements and being applicable to a plurality of different bias voltages in dependence on the operation modes, the method comprising:
specifying combinations of all the adjacent pairs of the wells located adjacently to each other within the semiconductor substrate, and the distance of each of all the adjacent pairs of the wells in reference to the layout data;
determining, for each of the wells, one or more applicable bias voltages to be applied to each of the wells for each of the operation modes in reference to the layout data and the information of the operation conditions;
determining, for each of all the adjacent pairs of the wells, a maximum voltage difference between the applicable bias voltages to be applied to each of all the adjacent pairs of wells among all the operation modes in reference to the operation conditions; and
verifying if the distance of each of all the adjacent pairs is within a respective permissive range determined by the corresponding maximum voltage difference between the applicable bias voltages to be applied to said each of the all adjacent pairs of the wells for all the combinations of all the adjacent pair of the wells.

2. The layout verification method according to claim 1, wherein the step of verifying is performed by applying a design rule between the same pair of terminals when the one terminal of the pair of terminals is judged as the same as the other device group connected to the other terminal of the pair of terminals, and by applying a design rule between the different pair of terminals when the one terminal of the pair of terminals is judged as different from the other device group connected to the other terminal of the pair of terminals.

3. The layout verification method according to claim 1 or 2, wherein the step of verifying is performed by applying a design rule between the different pair of terminals when any one of the input voltages of the pair of terminals is judged to be different from the remaining the pair of terminals.

4. The layout verification method according to claim 1, 2, or 3, further comprising:
verifying if an interval between the one device group connected to one terminal of the pair of terminals and the other device group connected to the other terminal of the pair of terminals is compliant with the design rules; and
outputting the verification result after the verifying if the distance of each of all the adjacent pairs is within a respective permissive range determined by the corresponding maximum voltage difference between the applicable bias voltages to be applied to said each of the all adjacent pairs of the wells for all the combination of all the adjacent pairs of the wells.

5. The layout verification method according to any preceding claim, further comprising detecting a interval between the one device group connected to one terminal of the pair of terminals and the other device group connected to the other terminal of the pair of terminals within the layout data.

6. A layout verification apparatus for verifying a layout of a semiconductor device having a memory storing layout data and information of operation conditions for a plurality of operation modes in which the semiconductor device is expected to assume during its testing and practical use, the semiconductor device including a semiconductor substrate of one conductivity type, a plurality of wells accommodating at least one of the circuit elements and being applicable to a plurality of different bias voltages in dependence of the operation modes, the apparatus comprising:
a specifier for specifying combinations of all the adjacent pairs of the wells located adjacently to each other within the semiconductor substrate, and intervals between each of the adjacent pairs of the wells in reference to the layout data;
a first determinator for determining, for each of the wells, one or more applicable bias voltages to be applied thereto in each of the operation modes with reference to the layout data and the information of the operation conditions;
a second determinator for determining, for each of the adjacent pairs of wells, a maximum voltage difference between the applicable bias voltages to be applied thereto among all the operation modes in reference to the operation conditions; and
a verifier for verifying if the interval between each of the adjacent pairs is within a respective permissive range determined by the corresponding maximum voltage difference between the applicable bias voltages to be applied thereto for all the combinations of adjacent pairs of the wells.

7. A program for verifying a layout of a semiconductor device by a computer having a memory storing layout data and information of operation conditions for a plurality of operation modes in which the semiconductor device is expected to assume during its testing and practical use, the semiconductor device including a semiconductor substrate of one conductivity type, a plurality of wells accommodating at least one of the circuit elements and being applicable to a plurality of different bias voltages in dependence on the operation modes, the program causing the computer to execute a verifying process comprising:
selecting a target item from the set of the plurality of items;
extracting a pair of terminals from the target item;
judging whether the input voltages of the pair of terminals are the same or not;
determining a design rule in accordance with the result of judging whether the input voltages of the pair of terminals are the same or not, the design rule being applicable to the intervals for one device group connected to one terminal of the pair of terminals and the other device group connected to the other terminal of the pair of terminals if the input voltages of the pair of terminals are the same; and
outputting the design rule so determined.

8. A computer-readable medium on which is stored the program according to claim 7.
